# EUROPÄISCHE PATENTSCHRIFT

(11) **EP 1 576 703 B1**
(45) Veröffentlichungstag und Bekanntmachung des Hinweises auf die Patenterteilung: **10.05.2006**
(21) Anmeldenummer: 03782292.1
(22) Anmeldetag: 03.12.2003
(51) Int. Cl.: H01R 31/08

(54) **FLACHKABELSTRANG**
FLAT CABLE HARNESS
FAISCEAU DE CABLES PLATS

(30) Priorität: 23.12.2002 DE 10260786
(43) Veröffentlichungstag der Anmeldung: 21.09.2005
(73) Patentinhaber: DaimlerChrysler AG, 70567 Stuttgart (DE)
(72) Erfinder: LAMANN, Uwe, 93161 Sinzing (DE); MÖLLER-GADEN, Jörg, 57080 Siegen (DE); OTT, Martin, 90530 Wendelstein (DE); RENNER, Guido, 97318 Kitzingen (DE)
(86) Internationale Anmeldenummer: PCT/EP2003/013631
(87) Internationale Veröffentlichungsnummer: WO 2004/059804

(56) Entgegenhaltungen:
- EP-A- 1 014 515
- FR-A- 2 565 425
- US-A1- 2002 009 919

## Beschreibung

Die vorliegende Erfindung betrifft einen Flachkabelstrang mit den Merkmalen des Oberbegriffs des Anspruchs 1.

Ein Flachkabelstrang umfasst wenigstens ein Flachkabel, das mindestens zwei Flachleiter enthält, die sich parallel zueinander erstrecken und mit einer gemeinsamen Isolierung gegeneinander und nach außen isoliert sind.

Unter Flachleitern werden im vorliegenden Zusammenhang einadrige Leiter verstanden, die im Querschnitt eine Breite besitzen, die erheblich größer ist als ihre Höhe. In einem Flachkabel sind dann mehrere solcher Flachleiter in deren Breitenrichtung nebeneinander angeordnet, so dass auch ein Flachkabel im Querschnitt eine erheblich größere Breite besitzt als Höhe oder Dicke. Die Flachleiter und somit das damit ausgestattete Flachkabel sind regelmäßig flexibel.

Aus der EP 1 014 515 A2 ist ein Verfahren zum Verbinden einzelner Flachleiter eines ersten Flachkabels jeweils mit einem Flachleiter eines zweiten Flachkabels, welches das erste Flachkabel kreuzt, bekannt. Die leitende Verbindung sich kreuzender Flachleiter wird im jeweiligen Kreuzungspunkt mittels Ultraschallschweißen erzielt. Mit Hilfe des bekannten Verfahrens können somit bei sich kreuzenden Flachkabeln einzelne Flachleiter besonders einfach elektrisch leitend miteinander verbunden werden.

Aus der EP 1 014 507 A2 ist es außerdem bekannt, eine Kreuzungsstelle, in der sich zwei Flachkabel kreuzen und in der einzelne Flachleiter der Flachkabel elektrisch leitend miteinander verbunden sind, mittels zwei Isolierplatten, die miteinander verclipst sind, zu schützen.

Die vorliegende Erfindung beschäftigt sich mit dem Problem, für einen Flachkabelstrang der eingangs genannten Art eine verbesserte Ausführungsform anzugeben, die insbesondere eine erhöhte Funktionalität besitzt und neue Anwendungsformen für den Flachkabelstrang eröffnet.

Dieses Problem wird erfindungsgemäß durch den Gegenstand des unabhängigen Anspruchs gelöst. Vorteilhafte Ausführungsformen sind Gegenstand der abhängigen Ansprüche.

Die Erfindung beruht auf dem allgemeinen Gedanken, mehrere Flachkabel parallel zueinander auszurichten, in ihrer Dickenrichtung aufeinander zu stapeln, miteinander zu einem gemeinsamen Kabelstrang zu verbinden und innerhalb dieses Kabelstrangs an ausgewählten Stellen vertikal benachbarte und/oder horizontal benachbarte Flachleiter elektrisch leitend miteinander zu verbinden. Durch diese Bauweise wird ein Kabelstrang bereit gestellt, in dem eine dreidimensionale Signalausbreitung möglich ist. D.h., die Signale können sich in Längsrichtung der Flachleiter, zwischen benachbarten Flachleitern innerhalb eines Flachkabels sowie zwischen benachbarten Flachleitern verschiedener Flachkabel innerhalb des Kabelstrangs ausbreiten. Durch einen gezielten Aufbau des erfindungsgemäßen Kabelstrangs ist es somit möglich, relativ komplexe Verknüpfungen und/oder Verschaltungen der einzelnen Flachleiter innerhalb des Kabelstrangs auszubilden, beispielsweise um damit verbundene Komponenten in einer gewünschten Weise miteinander zu verschalten. Diese Verschaltung der Komponenten kann somit quasi in den Kabelstrang integriert werden, wodurch zusätzliche Verbindungselemente und Verbindungsmaßnahmen entfallen können. Hierdurch ergibt sich eine Einsparung an Material, Zeit und Bauraum. Insbesondere ist es möglich, einen derartigen Flachkabelstrang als Bussystem auszugestalten. Durch die Ausbildung der vertikalen und horizontalen Verbindungen im Rahmen der Herstellung des Flachkabelstrangs kann der jeweilige Flachkabelstrang besonders einfach individuell an vorgegebene Schaltungsanforderungen angepasst werden.

Um die in den Flachkabelstrang integrierte Verschaltung der Flachleiter noch komplexer auszugestalten, wird vorgeschlagen, im Flachkabelstrang wenigstens einen Flachleiter mit wenigstens einer Unterbrechung zu versehen. Mit Hilfe solcher Unterbrechungen wird der jeweilige Flachleiter in seiner Längsrichtung in mehrere separate Abschnitte elektrisch getrennt, wodurch die Anzahl separater Leitungsabschnitte innerhalb des Flachkabelstrangs vergrößert wird und sich die Verschaltungsmöglichkeiten vervielfachen.

Beispielsweise kann eine Horizontalverbindung als Brücke ausgebildet sein, die wenigstens zwei Flachleiter miteinander verbindet. Die Brücke ist dabei zweckmäßig so angeordnet, dass sie keinen, nur einen oder mehrere benachbarte Flachleiter überbrückt, ohne diesen überbrückten Flachleiter oder ohne diese überbrückten Flachleiter zu kontaktieren. Mit Hilfe einer solchen, als zusätzliches Bauteil ausgebildeten Brücke, können herkömmlich gestaltete Flachleiter besonders einfach miteinander verbunden werden, so dass die beim erfindungsgemäßen Flachkabelstrang verwendeten Flachkabel grundsätzlich einen herkömmlichen Aufbau besitzen können, der im Rahmen des Aufbaus des Flachkabelstrangs in geeigneter Weise modifizierbar ist.

Von besonderem Vorteil ist eine Ausführungsform, bei der wenigstens eine Horizontalverbindung und/oder wenigstens eine Vertikalverbindung ein passives oder ein aktives elektronisches Bauteil aufweist oder durch ein solches gebildet ist. Passive elektronische Bauteile können beispielsweise ein Widerstand oder eine Diode sein. Aktive elektronische Bauteile sind beispielsweise ein Transistor oder ein Thyristor. Durch die Integration solcher elektronischer Bauteile in den erfindungsgemäßen Kabelstrang kann die Komplexität der darin realisierten Verschaltung der einzelnen, darin geführten Flachleiter weiter gesteigert werden. Insbesondere kann der erfindungsgemäße Kabelstrang zu einem integrierten Schaltkreis ausgestaltet werden.

Weitere wichtige Merkmale und Vorteile der Erfindung ergeben sich aus den Unteransprüchen, aus den Zeichnungen und aus der zugehörigen Figurenbeschreibung anhand der Zeichnungen.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Ein bevorzugtes Ausführungsbeispiel der Erfindung ist in den Zeichnungen dargestellt und wird in der nachfolgenden Beschreibung näher erläutert, wobei sich gleiche Bezugszeichen auf gleiche oder funktional gleiche oder ähnliche Bauteile beziehen.

Es zeigen, jeweils schematisch,
- Fig. 1: eine perspektivische Ansicht auf einen Ausschnitt eines erfindungsgemäßen Flachkabelstrangs mit drei Flachkabeln in einer Explosionsdarstellung,
- Fig. 2: einen Querschnitt durch den Flachkabelstrang entsprechend den Schnittlinien II in Fig. 1,
- Fig. 3: einen Querschnitt durch den Flachkabelstrang entsprechend den Schnittlinien III in Fig. 1,
- Fig. 4: einen Querschnitt durch den Flachkabelstrang entsprechend den Schnittlinien IV in Fig. 1 und
- Fig. 5: einen Querschnitt durch den Flachkabelstrang entsprechend den Schnittlinien V in Fig. 1.

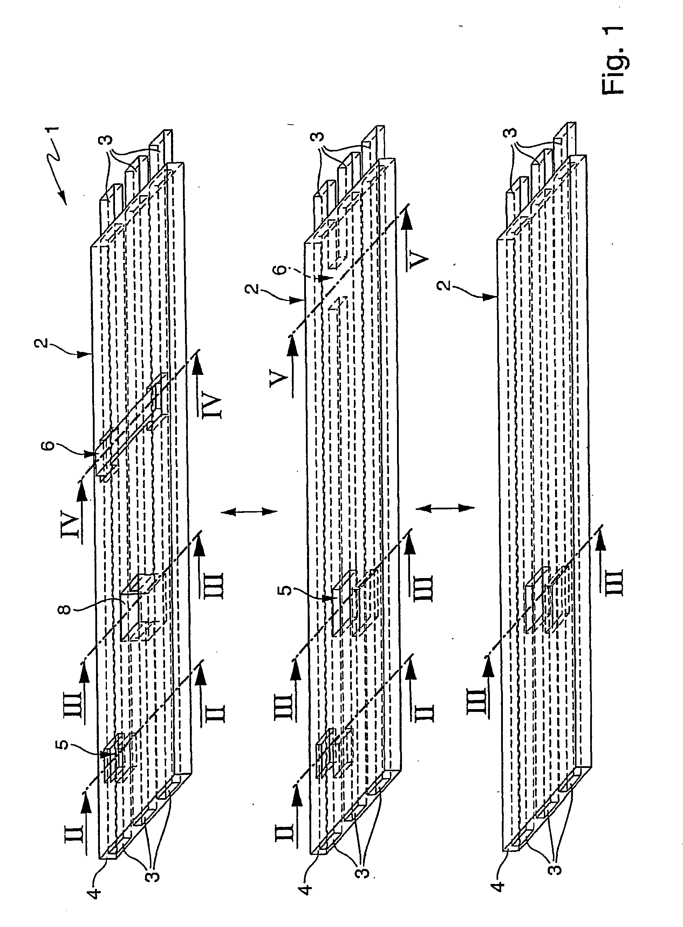

Entsprechend den Fig. 1 bis 5 umfasst ein erfindungsgemäßer Flachkabelstrang 1 mehrere, hier drei, Flachkabel 2, die jeweils mehrere, hier drei, Flachleiter 3 enthalten. Die Flachleiter 3 können durch Laminieren oder durch Extrudieren hergestellt werden. Die Flachkabel 2 umfassen jeweils eine Isolierung 4, welche die zugehörigen Flachleiter 3 umhüllt. Zweckmäßig besteht die Isolierung 4 aus zwei Isolierstoffbahnen, die unter Einschluss der Flachleiter 3 miteinander verklebt oder verschweißt sind. Wie aus den Fig. 1 bis 5 hervorgeht, besitzen die Flachleiter 3 einen Querschnitt, hier einen Rechteckquerschnitt, dessen Breite deutlich größer dimensioniert ist als deren Höhe. Des Weiteren sind die Flachleiter 3 im jeweiligen Flachkabel 2 bezüglich ihrer Breitenrichtung nebeneinander angeordnet, wobei sie außerdem parallel zueinander verlaufen. Die einzelnen Flachkabel 2 sind in der Höhenrichtung ihrer Flachleiter 3, also in der Dickenrichtung der einzelnen Flachkabel 2, aufeinander gestapelt oder geschichtet. Aneinander angrenzende Flachkabel 2 sind zweckmäßig miteinander verbunden, insbesondere verklebt oder verschweißt. Dementsprechend bilden die Flachkabel 2 des Flachkabelstrangs 1 eine zusammengehörende Einheit.

Die Positionierung und Stapelung der Flachkabel 2 erfolgt dabei so, dass die Flachleiter 3 benachbarter Flachkabel 2 in der Stapelrichtung, also in der Dickenrichtung der Flachkabel 2 deckungsgleich aufeinanderliegen.

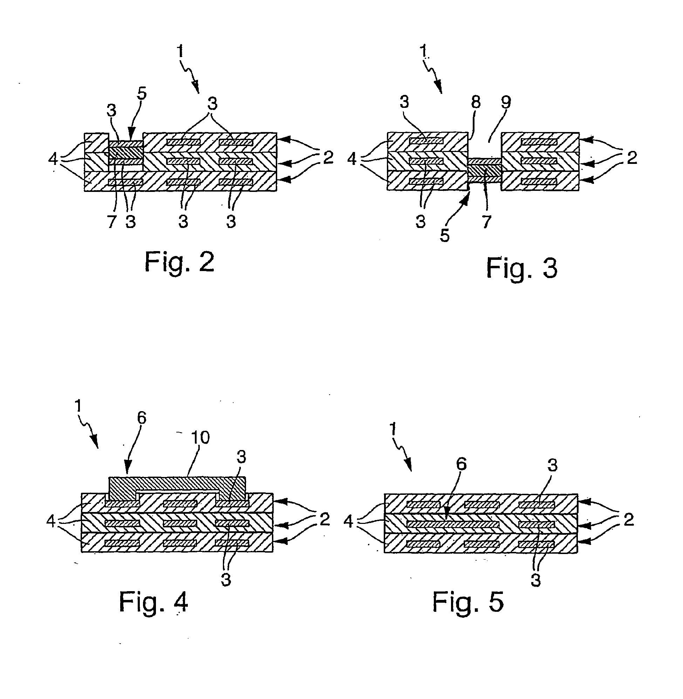

Erfindungsgemäß sind im Flachkabelstrang 1 zumindest eine Vertikalverbindung 5 und/oder wenigstens eine Horizontalverbindung 6 ausgebildet. In der hier gezeigten Ausführungsform sind exemplarisch zwei Vertikalverbindungen 5 (vgl. die Fig. 2 und 3) und zwei Horizontalverbindungen 6 (vgl. die Fig. 4 und 5) dargestellt. Bei jeder Vertikalverbindung 5 sind zumindest zwei Flachleiter 3, die in verschiedenen, hier in unmittelbar benachbarten, Flachkabeln 2 verlaufen, elektrisch leitend miteinander verbunden. Im Unterschied dazu sind bei den Horizontalverbindungen 6 zumindest zwei Flachleitungen 3, die in demselben Flachkabel 2 verlaufen, elektrisch leitend miteinander verbunden.

Entsprechend Fig. 2 und den Schnittlinien II in Fig. 1 kann eine Vertikalverbindung 5 beispielsweise dadurch hergestellt werden, dass im Bereich dieser Vertikalverbindung 5 die Isolierung 4 bei den oberen beiden Flachkabeln 2 an beiden Seiten der Flachleiter 3 entfernt wird. Anschließend können die beiden, auf diese Weise frei gelegten Flachleiter 3 mittels einer geeigneten Verbindungstechnik leitend miteinander verbunden werden. Beispielsweise eignen sich hierzu ein Schweißverfahren, insbesondere ein Ultraschall-Schweißverfahren, oder ein Laserlötverfahren oder ein Thermodenlötverfahren, wobei beim Löten die einzelnen Flachleiter 3 vorverzinnt sein können. Die elektrische Verbindung zwischen den beiden Flachleitern 3 im Bereich der Vertikalverbindung 5 ist in den Fig. 2 und 3 jeweils mit 7 bezeichnet.

Bei der Ausführungsform gemäß Fig. 3 entsprechend den Schnittlinien III in Fig. 1 ist die Vertikalverbindung 5 grundsätzlich gleich aufgebaut. Dort sind die Flachleiter 3 der unteren beiden Flachkabel 2 leitend miteinander verbunden. Aus fertigungstechnischen Gründen kann es dabei erforderlich sein, dass die Vertikalverbindung 5 durch das obere Flachkabel 2 hindurch zugänglich sein muss. Zu diesem Zweck ist im oberen Flachkabel 2 eine Aussparung 8 ausgebildet, die im Bereich der Vertikalverbindung 5 positioniert ist. Diese Aussparung 8 ist hier so dimensioniert, dass sie für die mittlere Flachleitung 3 des oberen Flachkabels 2 eine Unterbrechung 9 ausbildet. Mit Hilfe solcher Unterbrechungen 9 können die einzelnen Flachleiter 3 in ihrer Längsrichtung in mehrere voneinander unabhängige Abschnitte unterteilt werden.

Das partielle Abisolieren der Flachleiter 3 und/oder das Herstellen einer solchen Aussparung 8 kann beispielsweise mit Hilfe eines Lasers realisiert werden.

Entsprechend Fig. 4 sowie den Schnittlinien IV in Fig. 1 kann eine Horizontalverbindung 6 z.B. mit Hilfe einer Brücke 10 realisiert werden. Im vorliegenden Beispiel verbindet die Brücke 10 die beiden äußeren Flachleiter 3 des oberen Flachkabels 2. Der mittlere Flachleiter 3 wird dabei ohne Kontaktierung überbrückt. Ebenso ist eine Brücke 10 denkbar, die mehr als zwei Flachleiter 3 miteinander verbindet. Ebenso kann eine andere Brücke 10 auch zwei direkt benachbarte Flachleiter 3 miteinander verbinden.

Grundsätzlich ist es auch denkbar, eine solche Brücke 10 zur Verbindung von zwei Flachleitern 3 zu verwenden, die in unterschiedlichen Flachkabeln 2 verlaufen. Beispielsweise könnte eine solche Brücke 10 durch eine Aussparung 8 zu einem tiefer liegenden Flachleiter 3 gelangen. Die so erreichte Verbindung würde sich dann sowohl horizontal als auch vertikal erstrecken.

Gemäß Fig. 5 und den Schnittlinien V in Fig. 1 kann eine Horizontalverbindung 6 auch dadurch realisiert werden, dass im Bereich der Horizontalverbindung 6 zwei benachbarte Flachleiter 3 direkt aneinander angrenzen und dadurch elektrisch leitend miteinander verbunden. Erreicht wird dies z.B. dadurch, dass der eine Flachleiter 3 und/oder der andere Flachleiter 3 in Richtung auf den benachbarten Flachleiter 3 verbreitert ist und diesen kontaktiert. Ebenso ist es grundsätzlich möglich, im Rahmen der Herstellung der Flachkabel 2 die Flachleiter 3 im Bereich der Horizontalverbindung 6 mit Hilfe eines entsprechenden Verbindungselements elektrisch leitend miteinander zu verbinden, noch bevor die Isolierung 4 angebracht wird.

Besonders vorteilhaft sind Ausführungsformen, bei denen in eine oder mehrere Vertikalverbindungen 5 und/oder in eine oder mehrere Horizontalverbindungen 6 ein elektronisches Bauteil integriert wird, das passiv oder aktiv ausgestaltet sein kann. Insbesondere kann die jeweilige Horizontalverbindung 6 bzw. die jeweilige Vertikalverbindung 5 durch ein solches Bauteil gebildet sein. Beispielsweise kann es sich bei einem solchen Bauteil um eine Diode, einen Widerstand, einen Transistor oder einen Thyristor handeln. Mit Hilfe solcher Bauteile kann die Funktionalität des Kabelstrangs 1 nochmals beträchtlich erhöht werden. Insbesondere können durch die dreidimensionale Signalführung innerhalb des Kabelstrangs 1 komplexe Verschaltungen der einzelnen Flachleiter 3 untereinander realisiert werden.

In besonderer Weise eignet sich beispielsweise die Brücke 10 zur Realisierung einer Zusatzfunktion, indem die Brücke 10 als aktives oder passives Bauteil ausgestaltet ist.

Mit Hilfe der Erfindung ist es insbesondere möglich, ein Bussystem aufzubauen, das sich in besonderer Weise für eine Verwendung in einem Kraftfahrzeug eignet.

## Patentansprüche

1. Flachkabelstrang mit wenigstens zwei Flachkabeln (2), die jeder mindestens zwei Flachleiter (3) enthalten, die sich parallel zueinander erstrecken und mit einer gemeinsamen Isolierung (4) gegeneinander und nach außen isoliert sind, wobei
- mindestens zwei Flachkabel (2) aufeinander gestapelt und aufeinander befestigt sind, derart, dass sich die Flachleiter (3) eines der Flachkabel (2) parallel und in Stapelrichtung deckungsgleich zu den Flachleitern (3) des benachbarten Flachkabels (2) erstrecken,
- und wobei im Flachkabelstrang (1) wenigstens eine Vertikalverbindung (5) ausgebildet ist, in der wenigstens zwei in verschiedenen Flachkabeln (2) verlaufende Flachleiter (3) miteinander elektrisch leitend verbunden sind und/oder
- wobei im Flachkabelstrang (1) wenigstens eine Horizontalverbindung (6) ausgebildet ist, in der wenigstens zwei in demselben Flachkabel (2) verlaufende Flachleitungen (3) miteinander elektrisch leitend verbunden sind.

2. Flachkabelstrang nach Anspruch 1,
**dadurch gekennzeichnet ,**
**dass** im Flachkabelstrang (1) wenigstens ein Flachleiter (3) wenigstens eine Unterbrechung (9) aufweist.

3. Flachkabelstrang nach Anspruch 1 oder 2,
**dadurch gekennzeichnet ,**
**dass** wenigstens eine Horizontalverbindung (6) als Brücke (10) ausgebildet ist, die wenigstens zwei Flachleiter (3) miteinander verbindet und dabei keinen, einen oder mehrere benachbarte Flachleiter (3) überbrückt, ohne diese oder ohne diesen zu kontaktieren.

4. Flachkabelstrang nach einem der Ansprüche 1 bis 3,
**dadurch gekennzeichnet ,**
**dass** wenigstens eine Horizontalverbindung (6) und/oder wenigstens eine Vertikalverbindung (5) ein aktives oder passives elektronisches Bauteil aufweist oder durch ein solches gebildet ist.

5. Flachkabelstrang nach einem der Ansprüche 1 bis 4,
**dadurch gekennzeichnet ,**
**dass** wenigstens eine Horizontalverbindung (6) **dadurch** ausgebildet ist, dass ein Längsabschnitt des jeweiligen Flachleiters (3) verbreitert ist, derart, dass er den unmittelbar benachbarten Flachleiter (3) elektrisch kontaktiert.

6. Flachkabelstrang nach einem der Ansprüche 1 bis 5,
**dadurch gekennzeichnet ,**
**dass** die aufeinander gestapelten Flachkabel (2) durch Verkleben und/oder Verschweißen aneinander befestigt sind.

7. Flachkabelstrang nach einem der Ansprüche 1 bis 6,
**dadurch gekennzeichnet ,**
**dass** bei wenigstens einer Vertikalverbindung (5) in Stapelrichtung unmittelbar benachbarte Flachleiter (3) durch Schweißen, insbesondere Ultraschallschweißen, oder Laserlöten oder Thermodenlöten miteinander verbunden sind.

## Claims

1. Flat ribbon cable run having at least two flat ribbon cables (2), which each contain at least two flat conductors (3), which extend parallel to one another and are insulated from one another and from the outside by a common insulation (4),
- at least two flat ribbon cables (2) being stacked one on top of the other and being fixed to one another such that the flat conductors (3) of one of the flat ribbon cables (2) extend parallel and, in the stacking direction, congruently with respect to the flat conductors (3) of the adjacent flat ribbon cable (2),
- and at least one vertical connection (5) being formed in the flat ribbon cable run (1), at least two flat conductors (3), which run in different flat ribbon cables (2), being electrically conductively connected to one another in said vertical connection (5), and/or
- at least one horizontal connection (6) being formed in the flat ribbon cable run (1), at least two flat conductors (3), which run in the same flat ribbon cable (2), being electrically conductively connected to one another in said horizontal connection (6).

2. Flat ribbon cable run according to Claim 1, **characterized in that** at least one flat conductor (3) has at least one interruption (9) in the flat ribbon cable run (1).

3. Flat ribbon cable run according to Claim 1 or 2, **characterized in that** at least one horizontal connection (6) is in the form of a link (10), which connects at least two flat conductors (3) to one another and in the process bridges no, one or more adjacent flat conductors (3) without coming into contact with them or it.

4. Flat ribbon cable run according to one of Claims 1 to 3, **characterized in that** at least one horizontal connection (6) and/or at least one vertical connection (5) has an active or passive electronic component or is formed by such an active or passive electronic component.

5. Flat ribbon cable run according to one of Claims 1 to 4, **characterized in that** at least one horizontal connection (6) is formed by a longitudinal section of the respective flat conductor (3) being broadened such that it makes electrical contact with the directly adjacent flat conductor (3).

6. Flat ribbon cable run according to one of Claims 1 to 5, **characterized in that** the flat ribbon cables (2), which are stacked one on top of the other, are fixed to one another by means of adhesive bonding and/or welding.

7. Flat ribbon cable run according to one of Claims 1 to 6, **characterized in that**, in the case of at least one vertical connection (5), flat conductors (3), which are directly adjacent in the stacking direction, are connected to one another by means of welding, in particular ultrasound welding or laser soldering or thermode soldering.

## Revendications

1. Faisceau de câbles en nappe comprenant au moins deux câbles en nappe (2) qui comprennent chacun au moins deux conducteurs plats (3) qui s'étendent parallèlement l'un à l'autre et qui sont isolés l'un de l'autre et par rapport à l'extérieur avec un isolant (4) commun, au moins deux câbles en nappe (2) étant empilés l'un sur l'autre et fixés l'un sur l'autre de telle sorte que les conducteurs plats (3) de l'un des câbles en nappe (2) s'étendent en parallèle et en coïncidence dans le sens de l'empilement par rapport aux conducteurs plats (3) du câble en nappe (2) voisin et au moins une liaison verticale (5) étant réalisée dans le faisceau de câbles en nappe (1), dans laquelle au moins deux conducteurs plats (3) qui s'étendent dans des câbles en nappe (2) différents sont reliés électriquement ensemble, et/ou au moins une liaison horizontale (6) étant réalisée dans le faisceau de câbles en nappe (1), dans laquelle au moins deux conducteurs plats (3) qui s'étendent dans le même câble en nappe (2) sont reliés électriquement ensemble.

2. Faisceau de câbles en nappe selon la revendication 1, **caractérisé en ce que** dans le faisceau de câbles en nappe (1), au moins un conducteur plat (3) présente au moins une interruption (9).

3. Faisceau de câbles en nappe selon la revendication 1 ou 2, **caractérisé en ce qu'**au moins une liaison horizontale (6) est réalisée sous la forme d'un cavalier (10) qui relie au moins deux conducteurs plats (3) entre eux et qui franchit ici aucun, un ou plusieurs conducteurs plats (3) voisins sans établir de contact avec lui/eux.

4. Faisceau de câbles en nappe selon l'une des revendications 1 à 3, **caractérisé en ce qu'**au moins une liaison horizontale (6) et/ou au moins une liaison verticale (5) présente un composant électronique actif ou passif ou alors elle est formée par un tel composant.

5. Faisceau de câbles en nappe selon l'une des revendications 1 à 4, **caractérisé en ce qu'**au moins une liaison horizontale (6) est configurée en ce sens qu'une section longitudinale du conducteur plat (3) correspondant est élargie de telle sorte qu'elle établit un contact électrique avec le conducteur plat (3) directement voisin.

6. Faisceau de câbles en nappe selon l'une des revendications 1 à 5, **caractérisé en ce que** les câbles plats (2) empilés les uns sur les autres sont fixés les uns aux autres par collage et/ou soudage.

7. Faisceau de câbles en nappe selon l'une des revendications 1 à 6, **caractérisé en ce qu'**avec au moins une liaison verticale (5) dans le sens de l'empilement, les conducteurs plats (3) directement voisins sont reliés entre eux par soudage, notamment par soudage aux ultrasons, ou par brasage au laser ou par thermosoudage.
